# EUROPEAN PATENT APPLICATION

(11) **EP 4 748 869 A1**
(43) Date of publication of application: **27.05.2026**
(21) Application number: 24845429.0
(22) Date of filing: 11.07.2024
(51) Int. Cl.: C08G 59/66, C08G 59/68, C08L 63/00, C09J 163/00, C09K 3/10, H01L 23/29, H01L 23/31

(54) **EPOXY RESIN COMPOSITION, ADHESIVE AGENT, SEALING MATERIAL, CURED ARTICLE, SEMICONDUCTOR DEVICE, AND ELECTRONIC COMPONENT**

(30) Priority: 21.07.2023 JP 2023119048
(71) Applicant: Namics Corporation, Niigata-shi, Niigata 950-3131 (JP)
(72) Inventor: IWAYA Kazuki, Niigata-shi, Niigata 950-3131 (JP); OTSUBO Kodai, Niigata-shi, Niigata 950-3131 (JP); SHIGETA Nozomi, Niigata-shi, Niigata 950-3131 (JP); NAGATA Rieko, Niigata-shi, Niigata 950-3131 (JP)
(74) Representative: Hoffmann Eitle
(86) International application number: PCT/JP2024/025141
(87) International publication number: WO 2025/023048

(57) **Abstract**

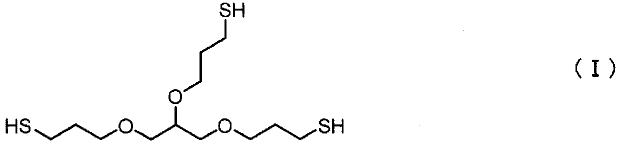

The present invention addresses the problem of providing: an epoxy resin composition with which it is possible to suppress the discoloration of an object having the composition applied thereto even when the composition contains a specific trithiol compound; an adhesive agent or a sealing material containing the composition; a cured article; and a semiconductor device or an electronic component. Provided are: an epoxy resin composition containing (A) an epoxy resin having a halogen content of 1600 ppm or less, (B) a thiol compound represented by chemical formula (I), and (C) a basic curing catalyst; an adhesive agent or a sealing material containing the epoxy resin composition; a cured article; and a semiconductor device or an electronic component.

## Description

### TECHNICAL FIELD

The present invention relates to an epoxy resin composition, an adhesive or sealant containing the same, a cured product thereof, a semiconductor device and an electronic component containing the cured product.

### BACKGROUND ART

Currently, in assembling and mounting a semiconductor device or an electronic component, such as a semiconductor chip, an adhesive, a sealant and the like containing a curable resin composition, in particular, an epoxy resin composition, are often used for the purpose of maintaining reliability or the like. It is well known that compounds having a plurality of thiol groups in the molecule are useful as a curing agent for epoxy resins. For example, an epoxy resin composition using a polythiol compound as a curing agent and containing a reaction product of an amine and an epoxy compound as a curing accelerator is known (For example, Patent Literatures 1 and 2).

Patent Literature 3 discloses a trithiol compound having the following structural formula: 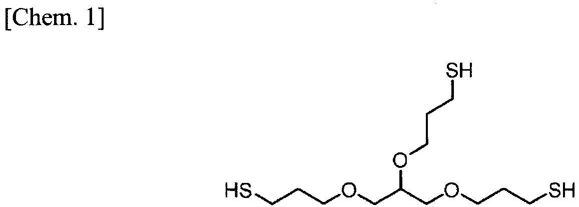 which can be used as a curing agent for various resins.

### CITATION LIST

### Patent Literature

Patent Literature 1: Japanese Patent Application Laid-Open No. H06-211969
Patent Literature 2: Japanese Patent Application Laid-Open No. H06-211970
Patent Literature 3: Japanese Patent Application Laid-Open No. 2022-180364

### SUMMARY OF INVENTION

Patent Literature 3 discloses that when a resin composition containing the trithiol compound is used as an adhesive, the adhesive strength with an adherend, which has been a conventional problem, can be improved. The present inventors found that when the epoxy resin composition containing the trithiol compound was applied to a metal substrate, remarkable discoloration was observed on the metal substrate in comparison with epoxy resin compositions containing other conventional thiol compounds in a moisture resistance reliability test. Discoloration can be a problem, especially in semiconductor devices and electronic components where the distance between components is short, for example, in addition to lowering a commercial value due to poor appearance, it can lead to corrosion, and once the corrosion product is generated, it progresses to the surrounding metal.

An object of the present invention is to provide an epoxy resin composition, an adhesive or sealant containing the same, a cured product, and a semiconductor device or an electronic component, in which discoloration of an adherend applied is suppressed even when the epoxy resin composition contains a specific trithiol compound.

Specific means for solving the above problems are as follows.

Embodiments of the present invention include an epoxy resin composition, an adhesive or sealant, a cured product, and a semiconductor device or an electronic component, as follows.
(1) An epoxy resin composition comprising
   (A) an epoxy resin having a halogen content of 1600 ppm or less,
   (B) a thiol compound represented by chemical formula (I): 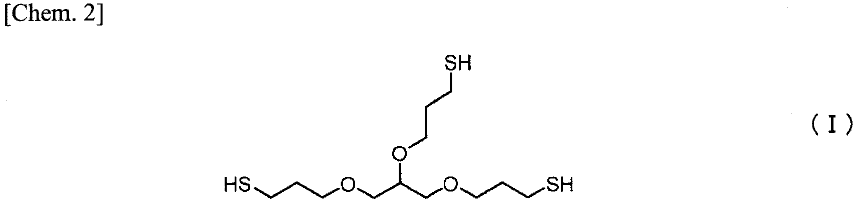
   and (C) a basic curing catalyst.
(2) The epoxy resin composition according to the above aspect (1), wherein the (C) basic curing catalyst is a thermal latent curing catalyst.
(3) The epoxy resin composition according to the above aspect (1) or (2), wherein a ratio of an equivalent number of the epoxy group of the component (A) to an equivalent number of the thiol group of the component (B) ([an equivalent number of the epoxy group of the component (A)] / [an equivalent number of the thiol group of the component (B)]) is 0.1 to 10.
(4) The epoxy resin composition according to any one of the above aspects (1) to (3), which is configured with the components (A) to (C) being contained in a single container.
(5) The epoxy resin composition according to any one of the above aspects (1) to (3), which is configured with the components (A) to (C) being separated into two or more containers.
(6) An adhesive or sealant comprising the epoxy resin composition according to any one of the above aspects (1) to (5).
(7) The adhesive or sealant according to the above aspect (6), which is for a semiconductor device or an electronic component.
(8) A cured product in which the epoxy resin composition according to any one of the above aspects (1) to (5), or the adhesive or sealant according to the above aspect (6) or (7) has been cured.
(9) A semiconductor device or an electronic component comprising the cured product according to the above aspect (8).

According to embodiments of the present invention, there are provided an epoxy resin composition, an adhesive or a sealant containing the same, a cured product obtained by curing them, and a semiconductor device or an electronic component comprising the cured product, in which discoloration of an applied adherend is suppressed even when the epoxy resin composition contains a specific trithiol compound.

### BRIEF DESCRIPTION OF DRAWINGS

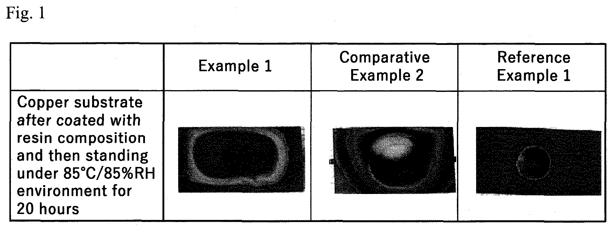

[Fig. 1] Fig. 1 is a photograph taken from above of copper substrates used for discoloration evaluation of Example 1, Comparative Example 2, and Reference Example 1, after standing under an 85°C/85%RH environment for 20 hours.

### DESCRIPTION OF EMBODIMENTS

In accordance with common practice in the field of synthetic resins, this description may use names containing the term "resin", which usually refers to polymers (especially synthetic polymers), for components of curable resin compositions prior to curing, even though the components are not polymers, for example, are prepolymer compounds prior to curing.

### [Epoxy Resin Composition]

The epoxy resin composition according to one embodiment of the present invention comprises:
(A) an epoxy resin having a halogen content of 1600 ppm or less,
(B) a thiol compound represented by chemical formula (I): 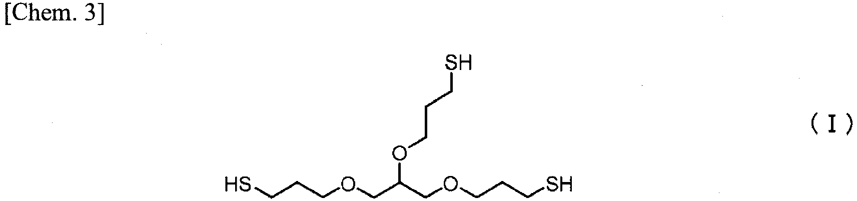
and (C) a basic curing catalyst. According to this embodiment, it is possible to provide an epoxy resin composition in which discoloration of an applied adherend is suppressed even when the epoxy resin composition contains the thiol compound represented by chemical formula (I).

### (A) Epoxy resin having a halogen content of 1600 ppm or less

The epoxy resin composition of this embodiment includes (A) an epoxy resin having a halogen content of 1600 ppm or less (hereinafter also referred to as "component (A)"). By including (A) an epoxy resin having a halogen content of 1600 ppm or less as a main agent, it is possible to provide an epoxy resin composition in which discoloration of an applied adherend is suppressed even when the epoxy resin composition contains the thiol compound represented by chemical formula (I) as a curing agent of the epoxy resin.

The present inventors have found that although the epoxy resin composition containing the thiol compound represented by chemical formula (I) has excellent adhesive strength, when the epoxy resin composition is applied to a metal substrate, remarkable discoloration is observed on the metal substrate as compared with epoxy resin compositions containing other conventional thiol compounds in a moisture resistance reliability test. Although the reason for this discoloration is not clear, the present inventors presumed as follows. First, since the thiol compound represented by chemical formula (I) has much fewer portions having polarity other than the thiol group in its structure than other conventional thiol compounds, the thiol group is relatively easy to approach a metal surface when contacting a highly polar surface such as a metal surface. Therefore, when the epoxy resin composition is applied to a metal substrate, the thiol compound represented by chemical formula (I) is more likely to have its thiol group on the metal surface than other conventional thiol compounds. The present inventors considered that under the moisture resistance reliability test, some reaction occurred between the thiol group on the metal surface, a halogen, water, and the metal because the halogen and water, which have high affinity with the polar metal surface, moved to the metal surface, and the discoloration appeared. Therefore, in order to reduce a halogen concentration on the metal surface, the present inventors controlled a halogen content of the epoxy resin contained in the resin composition to a certain amount or less, and as a result, found that the discoloration of the metal substrate was suppressed.

The halogen content of the epoxy resin as component (A) is 1600 ppm or less, and preferably 1500 ppm. The halogen is at least one selected from fluorine, chlorine, bromine, and iodine. The epoxy resin can include chlorine in a synthesis process. In one embodiment, the chlorine content of the epoxy resin as component (A) is 1600 ppm or less, and preferably 1500 ppm. In this description, the halogen content of the epoxy resin is, for example, a total chlorine content when the halogen is chlorine, and can be determined by a known method, for example, a sample combustion-ion chromatography method in accordance with BS EN 14582:2007. As a principle, in the method, a sample is combusted by introducing oxygen or argon into a heated quartz combustion tube, the generated combustion gas is absorbed into an absorption liquid, and the absorption liquid is fractionated and quantified by ion chromatography to determine the content in the sample. A pretreatment method thereof includes a flask combustion method, a bomb combustion method, a combustion tube method, and the like.

The epoxy resin as component (A) is not particularly limited as long as it has a halogen content of 1600 ppm or less and has at least two epoxy groups. The epoxy resin is a generic term for thermosetting resins that can be cured by forming a crosslinked network with epoxy groups present in the molecule, and includes a prepolymer compound before curing. In consideration of securing heat resistance, the epoxy resin is more preferably one having 2 to 6 epoxy groups, and further preferably one having two epoxy groups. The epoxy resin may be liquid or solid at 25°C, and is preferably liquid at 25°C.

Epoxy resins are roughly classified into aromatic epoxy resins and epoxy resins having no aromatic ring.

The aromatic epoxy resin is an epoxy resin having a structure including an aromatic ring such as a benzene ring. Many epoxy resins used conventionally are often of this type, such as bisphenol A-type epoxy resins. Examples of aromatic epoxy resins include, but are not limited to:
- bisphenol A-type epoxy resins;
- branched multifunctional bisphenol A-type epoxy resins such as p-glycidyloxyphenyldimethyl trisbisphenol A diglycidyl ether;
- bisphenol F-type epoxy resins;
- novolac-type epoxy resins;
- tetrabromobisphenol A-type epoxy resins;
- fluorene-type epoxy resins;
- biphenyl aralkyl-type epoxy resins;
- diepoxy compounds such as 1, 4-phenyldimethanol diglycidyl ether;
- biphenyl-type epoxy resins such as 3,3',5,5'-tetramethyl-4,4'-diglycidyloxybiphenyl;
- glycidylamine-type epoxy resins such as diglycidylaniline, diglycidyltoluidine, triglycidyl-p-aminophenol, and tetraglycidyl-m-xylylenediamine; and
- naphthalene ring-containing epoxy resins.

These resins may be used alone, or two or more may be used in combination. As the aromatic epoxy resin, bisphenol F-type epoxy resins, bisphenol A-type epoxy resins and glycidylamine-type epoxy resins are preferable, and among these, those having an epoxy equivalent weight of 90 to 500 g/eq are more preferable, and those having an epoxy equivalent weight of 90 to 400 g/eq are further preferable. The aromatic epoxy resin may be modified by an oxyalkylene modification such as EO (ethylene oxide) modification or PO (propylene oxide) modification. The aromatic epoxy resin is preferably liquid at 25°C. The viscosity at 25°C is preferably 0.1 to 100 Pa·s, more preferably 0.5 to 100 Pa·s, and particularly preferably 1 to 100 Pa·s.

In this description, unless otherwise specified, the viscosity is expressed as a value measured according to Japanese Industrial Standard JIS K6833. Specifically, it can be determined by measuring with an E-type viscometer at a rotation speed of 10rpm. There are no particular restrictions on an equipment used, a rotor, or a measuring range.

The epoxy resin having no aromatic ring includes, for example, an aliphatic epoxy resin and an epoxy resin having a heterocycle.

Examples of aliphatic epoxy resins include, but are not limited to:
- diepoxy compounds such as (poly)ethylene glycol diglycidyl ether, (poly)propylene glycol diglycidyl ether, butanediol diglycidyl ether, neopentyl glycol diglycidyl ether, 1,6-hexanediol diglycidyl ether, trimethylolpropane diglycidyl ether, polytetramethylene glycol diglycidyl ether, glycerol diglycidyl ether, neopentyl glycol diglycidyl ether, cyclohexane-type diglycidyl ether, and dicyclopentadiene-type diglycidyl ether;
- triepoxy compounds such as trimethylolpropane triglycidyl ether, and glycerol triglycidyl ether;
- alicyclic epoxy resins such as vinyl(3, 4-cyclohexene) dioxide, and 2-(3,4-epoxycyclohexyl)-5,1-spiro-(3,4-epoxycyclohexyl)-m-dioxane;
- hydrogenated bisphenol A-type diepoxy resins such as hydrogenated bisphenol A diglycidyl ether;
- glycidylamine-type epoxy resins such as tetraglycidyl bis(aminomethyl) cyclohexane;
- hydantoin-type epoxy resins such as 1,3-diglycidyl-5-methyl-5-ethylhydantoin; and
- epoxy resins having silicone skeletons such as 1,3-bis(3-glycidoxypropyl)-1,1,3,3-tetramethyldisiloxane.

As the aliphatic epoxy resins, those having an epoxy equivalent weight of 90 to 450 g/eq are preferable. They are also preferably liquid at 25°C. The viscosity at 25°C is preferably 10 to 10,000 mPa·s, and more preferably 10 to 5,000 mPa·s.

Examples of the epoxy resins having a heterocycle include isocyanuric acid-type epoxy resins and glycoluril-type epoxy resins. As the epoxy resins having a heterocycle, those having an epoxy equivalent weight of 80 to 450 g/eq are preferable. Further, from the view of workability, they are also preferably liquid at 25°C. Further, the viscosity at 25°C is preferably 100 to 50,000 mPa·s, and more preferably 100 to 5,000 mPa·s. On the other hand, from the view of adhesion, the epoxy resins having a heterocycle are preferably solid at 25°C.

With regard to the (A) epoxy resin, any one kind may be used, or two or more kinds may be used in combination.

In the present embodiment, a content of the (A) epoxy resin in the epoxy resin composition is preferably 10 to 90 % by weight, more preferably 15 to 85 % by weight, and further preferably 20 to 80 % by weight, based on a total weight of the epoxy resin composition.

In the present embodiment, it is preferable that the epoxy resin composition does not contain an epoxy resin having a halogen content of more than 1600 ppm. In one aspect, when the epoxy resin composition contains an epoxy resin having a halogen content of more than 1600 ppm, there may be a portion having a locally high halogen concentration in the epoxy resin composition, and local discoloration may occur. In applications such as adhesives and sealants for semiconductor devices and electronic components, in which the epoxy resin composition is used in small areas, even local discoloration may lead to corrosion and may cause electrical defects. When the epoxy resin composition contains an epoxy resin having a halogen content of more than 1600 ppm, the amount thereof is, for example, 10 parts by weight or less, and preferably 5 parts by weight or less, based on 100 parts by weight of the epoxy resin as a whole. The halogen content in the epoxy resin as a whole is 1600 ppm or less, and preferably 1500 ppm or less. The halogen content in the epoxy resin composition as a whole is 1600 ppm or less, and preferably 1500 ppm or less.

### (B) Thiol compound represented by chemical formula (I)

The epoxy resin composition of the present embodiment contains (B) a thiol compound represented by chemical formula (I): 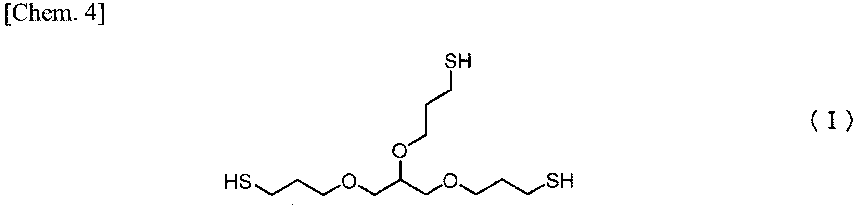 (1,2,3-tris(3-mercaptopropoxy)propane) (hereinafter also referred to as "component (B)"). The thiol compound represented by chemical formula (I) acts as a curing agent for an epoxy resin. The thiol compound represented by chemical formula (I) can be synthesized by, for example, reacting 1,2,3-triallyloxypropane with thiocarboxylic acid and subjecting the obtained thioester to solvolysis, according to a method described in Patent Literature 3 (Japanese Patent Application Laid-Open No. 2022-180364) or Japanese Patent Application Laid-Open No. 2023-126883.

The (B) thiol compound represented by chemical formula (I) acts as a curing agent for an epoxy resin, and the curing agent may contain by-products produced in the synthesis of the thiol compound represented by chemical formula (I). Examples of the by-products include, but are not limited to, compounds represented by chemical formulae (I-1) to (I-9) below described in Japanese Patent Application Laid-Open No. 2022-180364.

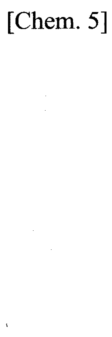

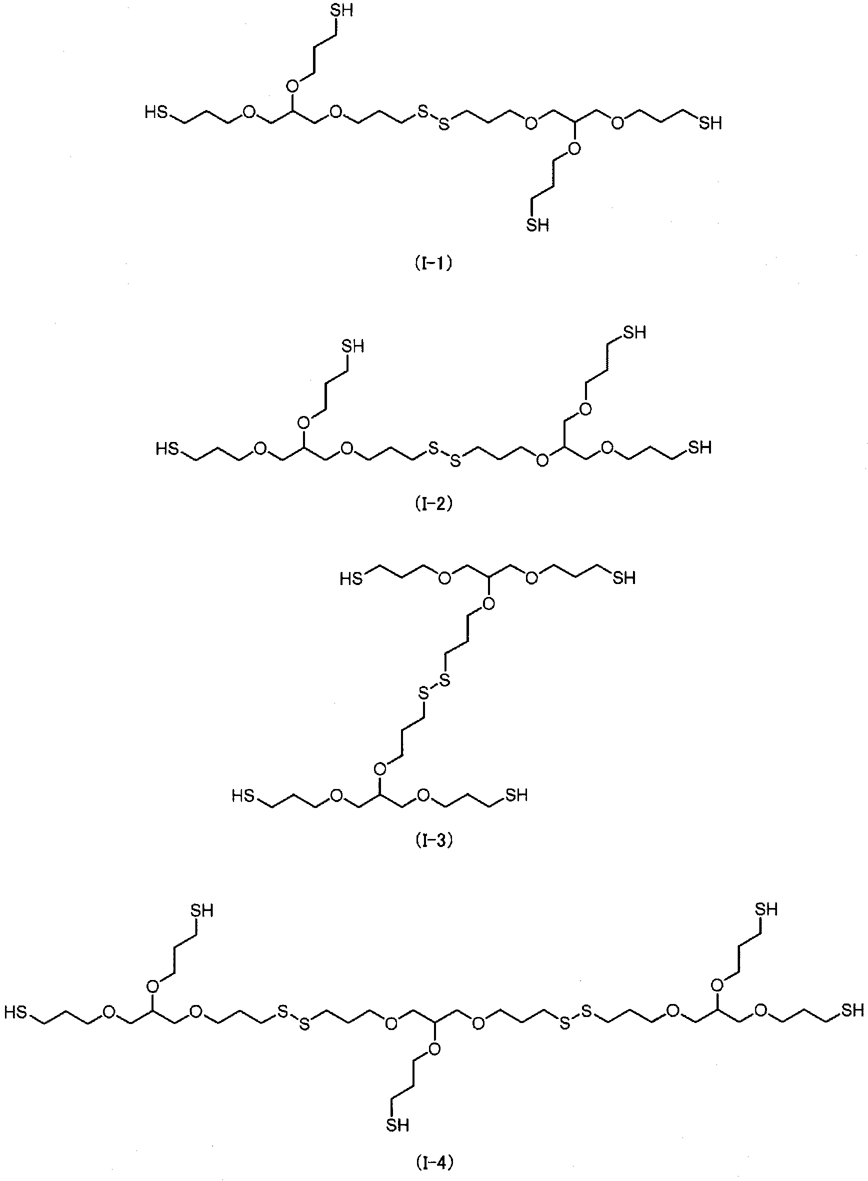

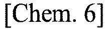

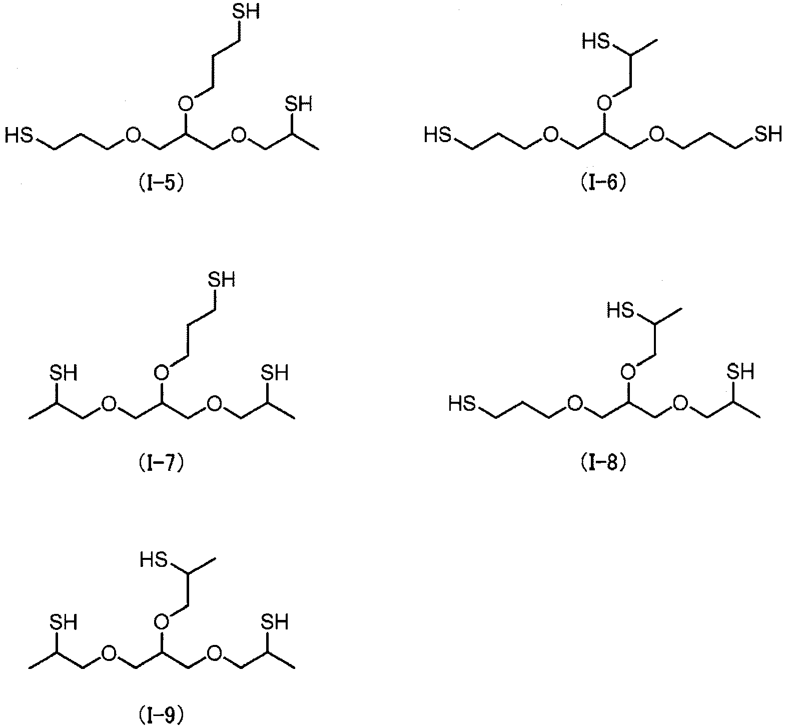

The by-products also include, but are not limited to, (0) thiol compounds represented by chemical formulae (I-1) to (I-45) as described in Japanese Patent Application Laid-Open No. 2023-126883, (1) multimers (for example, dimers and trimers) of these thiol compounds, (2) condensates of two or more kinds selected from these thiol compounds, and (3) condensates of one or more kinds selected from these thiol compounds with one or more kinds selected from thiol compounds represented by chemical formulae (IV-1) to (IV-6) as described in Japanese Patent Application Laid-Open No. 2023-126883.

When component (B) contains by-products of the thiol compound represented by chemical formula (I), for example, compounds represented by chemical formulae (I-1) to (I-9) as described in Japanese Patent Application Laid-Open No. 2022-180364 or compounds as described in Japanese Patent Application Laid-Open No. 2023-126883, a ratio of a content of the by-products of the thiol compound represented by chemical formula (I) to a content of the thiol compound represented by chemical formula (I) is preferably 0.02 to 0.3, more preferably 0.02 to 0.25, further preferably 0.05 to 0.25, and most preferably 0.05 to 0.20.

The ratio of the content of each compound in the curing agent is a value calculated using a size of a peak area of each component when the curing agent is subjected to liquid chromatography analysis.

In the present embodiment, a content of component (B) in the epoxy resin composition is preferably 1 to 70 % by weight, more preferably 10 to 60 % by weight, and further preferably 20 to 50 % by weight, based on a total weight of the epoxy resin composition. Since component (B) has very few polar portions other than the thiol group in its structure compared with other conventional thiol compounds, the thiol group is relatively easy to approach a metal surface when contacting a highly polar surface such as a metal surface. Therefore, even when the content of component (B) in the epoxy resin composition is small, discoloration may occur on the metal substrate.

In the present embodiment, a ratio of an equivalent number of the epoxy group of the component (A) to an equivalent number of the thiol group of the component (B) ([an equivalent number of the epoxy group of the component (A)] / [an equivalent number of the thiol group of the component (B)]) is preferably 0.1 to 10, and more preferably 0.2 to 10, 0.3 to 10, 0.4 to 10, or 0.5 to 10.

In this description, a functional group equivalent weight such as a thiol equivalent weight and an epoxy equivalent weight represents a molecular weight of a compound per functional group. An equivalent number of the functional group, such as an equivalent number of the thiol group and an equivalent number of the epoxy group represents a number of functional groups (an equivalent number) per compound weight (charged amount).

The epoxy equivalent weight of an epoxy resin is theoretically a number obtained by dividing a molecular weight of the epoxy resin by a number of epoxy groups in one molecule. The actual epoxy equivalent weight can be determined by a method described in JIS K7236. The equivalent number of the epoxy group of an epoxy resin is a number of epoxy groups (an equivalent number) per weight (charged amount) of the epoxy resin, and is a quotient (when a plurality of epoxy resins are included, a sum of such quotients for each epoxy resin) obtained by dividing a weight (g) of the epoxy resin by the epoxy equivalent weight of the epoxy resin.

The thiol equivalent weight of a thiol compound is theoretically a number obtained by dividing a molecular weight of the thiol compound by a number of thiol groups in one molecule. The actual thiol equivalent weight can be determined, for example, by determining a thiol value by potentiometry. This method is widely known and is disclosed, for example, in paragraph 0079 of Japanese Patent Application Laid-Open No. 2012-153794. The equivalent number of the thiol group of a thiol compound is a number of thiol groups (an equivalent number) per weight (charged amount) of the thiol compound, and is a quotient (when a plurality of thiol compounds are included, a sum of such quotients for each thiol compound) obtained by dividing a weight (g) of the thiol compound by the thiol equivalent weight of the thiol compound.

### (C) Basic curing catalyst

The epoxy resin composition of the present embodiment contains (C) a basic curing catalyst (hereinafter also referred to as "component (C)"). By using component (C), the epoxy resin composition of the present embodiment can be cured in a short time even under a low temperature condition. The basic curing catalyst used in the present embodiment is not particularly limited as long as it is a curing catalyst for an epoxy resin, and any known catalyst may be used.

Component (C) is preferably a latent curing catalyst. The latent curing catalyst is a compound which is inactive at room temperature and is activated by heating to function as a curing catalyst. Examples of the latent curing catalyst include imidazole compounds which are solid at room temperature; solid dispersion type amine adduct based latent curing catalysts such as a reaction product of an amine compound and an epoxy compound (amine-epoxy adduct based); and a reaction product of an amine compound and an isocyanate compound or an urea compound (urea type adduct based). The component (C) is preferably a solid dispersion type amine adduct based latent curing catalyst from the views of pot life and curability.

Examples of the imidazole compounds which are solid at room temperature include, but are not limited to, 2-heptadecylimidazole, 2-phenyl-4,5-dihydroxymethylimidazole, 2-undecylimidazole, 2-phenyl-4-methyl-5-hydroxymethylimidazole, 2-phenyl-4-benzyl-5-hydroxymethylimidazole, 2,4-diamino-6-(2-methylimidazolyl-(1))-ethyl-S-triazine, 2,4-diamino-6-(2'-methylimidazolyl-(1)')-ethyl-S-triazine-isocyanuric acid adduct, 2-methylimidazole, 2-phenylimidazole, 2-phenyl-4-methylimidazole, 1-cyanoethyl-2-phenylimidazole, 1-cyanoethyl-2-methylimidazole-trimellitate, 1-cyanoethyl-2-phenylimidazole-trimellitate, N-(2-methylimidazolyl-1-ethyl)-urea, and N,N'-(2-methylimidazolyl-(1)-ethyl)-adipoyldiamide.

Examples of the epoxy compounds used as one of raw materials for the production of the solid dispersion type amine adduct based latent curing catalysts (amine-epoxy adduct based) include, but are not limited to, polyglycidyl ethers obtained by reacting epichlorohydrin with polyhydric phenols such as bisphenol A, bisphenol F, catechol and resorcinol, or polyhydric alcohols such as glycerin and polyethylene glycol; glycidyl ether esters obtained by reacting epichlorohydrin with hydroxycarboxylic acids such as p-hydroxybenzoic acid and β-hydroxynaphthoic acid; polyglycidyl esters obtained by reacting epichlorohydrin with polycarboxylic acids such as phthalic acid and terephthalic acid; glycidylamine compounds obtained by reacting epichlorohydrin with 4,4'-diaminodiphenylmethane, m-aminophenol or the like; further, polyfunctional epoxy compounds such as epoxidized phenol novolac resins, epoxidized cresol novolac resins, and epoxidized polyolefins, and monofunctional epoxy compounds such as butyl glycidyl ether, phenyl glycidyl ether, and glycidyl methacrylate.

Amine compounds used as another raw material for the production of the solid dispersion type amine adduct based latent curing catalysts may be those having at least one active hydrogen capable of undergoing an addition reaction with an epoxy group in the molecule and at least one functional group selected from primary amino groups, secondary amino groups, and tertiary amino groups in the molecule. Examples of such amine compounds are shown below, but are not limited thereto. Examples thereof include, but are not limited to, aliphatic amines such as diethylenetriamine, triethylenetetramine, n-propylamine, 2-hydroxyethylaminopropylamine, cyclohexylamine, and 4,4'-diamino-dicyclohexylmethane; aromatic amine compounds such as 4,4'-diaminodiphenylmethane and 2-methylaniline; and heterocyclic compounds containing a nitrogen atom(s) such as 2-ethyl-4-methylimidazole, 2-ethyl-4-methylimidazoline, 2,4-dimethylimidazoline, piperidine and piperazine.

Among these compounds, especially compounds having a tertiary amino group in the molecule are raw materials for providing latent curing catalysts having excellent curing accelerating ability. Examples of such compounds include, but are not limited to, primary or secondary amines having a tertiary amino group in the molecule, such as amine compounds such as dimethylaminopropylamine, diethylaminopropylamine, di-n-propylaminopropylamine, dibutylaminopropylamine, dimethylaminoethylamine, diethylaminoethylamine, and N-methylpiperazine, and imidazole compounds such as 2-methylimidazole, 2-ethylimidazole, 2-ethyl-4-methylimidazole, and 2-phenylimidazole; and alcohols, phenols, thiols, carboxylic acids and hydrazides having a tertiary amino group in the molecule, such as 2-dimethylaminoethanol, 1-methyl-2-dimethylaminoethanol, 1-phenoxymethyl-2-dimethylaminoethanol, 2-diethylaminoethanol, 1-butoxymethyl-2-dimethylaminoethanol, 1-(2-hydroxy-3-phenoxypropyl)-2-methylimidazole, 1-(2-hydroxy-3-phenoxypropyl)-2-ethyl-4-methylimidazole, 1-(2-hydroxy-3-butoxypropyl)-2-methylimidazole, 1-(2-hydroxy-3-butoxypropyl)-2-ethyl-4-methylimidazole, 1-(2-hydroxy-3-phenoxypropyl)-2-phenylimidazoline, 1-(2-hydroxy-3-butoxypropyl)-2-methylimidazoline, 2-(dimethylaminomethyl)phenol, 2,4,6-tris(dimethylaminomethyl)phenol, N-β-hydroxyethylmorpholine, 2-dimethylaminoethanethiol, 2-mercaptopyridine, 2-benzimidazole, 2-mercaptobenzimidazole, 2-mercaptobenzothiazole, 4-mercaptopyridine, N,N-dimethylaminobenzoic acid, N,N-dimethylglycine, nicotinic acid, isonicotinic acid, picolinic acid, N, N-dimethylglycine hydrazide, N,N-dimethylpropionic acid hydrazide, nicotinic acid hydrazide, and isonicotinic acid hydrazide.

Examples of isocyanate compounds used as further another raw material for the production of the solid dispersion type amine adduct based latent curing catalysts include monofunctional isocyanate compounds such as n-butyl isocyanate, isopropyl isocyanate, phenyl isocyanate and benzyl isocyanate; and polyfunctional isocyanate compounds such as hexamethylene diisocyanate, toluene diisocyanate, 1,5-naphthalene diisocyanate, diphenylmethane-4,4'-diisocyanate, isophorone diisocyanate, xylylene diisocyanate, para-phenylene diisocyanate, 1,3,6-hexamethylene triisocyanate and bicycloheptane triisocyanate; and further, terminal isocyanate group-containing compounds obtained by the reaction of the above polyfunctional isocyanate compound with an active hydrogen compound, and the like can be used. Examples of such terminal isocyanate group-containing compounds include, but are not limited to, an addition compound having a terminal isocyanate group obtained by the reaction of toluene diisocyanate with trimethylolpropane and an addition compound having a terminal isocyanate group obtained by the reaction of toluene diisocyanate with pentaerythritol.

Examples of the urea compounds include, but are not limited to, urea and thiourea.

The solid dispersion type latent curing catalyst which can be used in the present embodiment is, for example, a combination of (a) two components of the amine compound and the epoxy compound as mentioned above, (b) three components of these two components and the active hydrogen compound, or (c) two or three components of the amine compound, and the isocyanate compound and/or the urea compound. These can be easily prepared by taking each component, mixing them, reacting them at a temperature from room temperature to 200°C, cooling and solidifying the reaction product, and then pulverizing it, or reacting the components in a solvent such as methyl ethyl ketone, dioxane or tetrahydrofuran, desolvating the reaction product, and then pulverizing the solid content thereof.

Typical examples of commercially available latent curing catalyst products include, but are not limited to, amine-epoxy adduct based products (amine adduct based) such as Ajicure PN-23 (trade name; Ajinomoto Fine-Techno Co., Inc.), Ajicure PN-40 (trade name; Ajinomoto Fine-Techno Co., Inc.), Ajicure PN-50 (trade name; Ajinomoto Fine-Techno Co., Inc.), Hardner X-3661S (trade name; A.C.R. (K.K.)), Hardner X-3670S (trade name; A.C.R (K.K.)), Novacure HX-3742 (trade name; Asahi Kasei Corporation), Novacure HX-3721 (trade name; Asahi Kasei Corporation), Novacure HXA9322HP (trade name; Asahi Kasei Corporation), Novacure HXA3922HP (trade name; Asahi Kasei Corporation), Novacure HXA3932HP (trade name; Asahi Kasei Corporation), Novacure HXA5945HP (trade name; Asahi Kasei Corporation), Novacure HXA5911HP (trade name; Asahi Kasei Corporation), and Novacure HXA9382HP (trade name; Asahi Kasei Corporation); and urea type adduct based products such as Fujicure FXE-1000 (trade name; T & K TOKA Co., Ltd.), Fujicure FXR-1020 (trade name; T & K TOKA Co., Ltd.), Fujicure FXR-1030 (trade name; T & K TOKA Co., Ltd.), Fujicure FXR1121 (trade name; T & K TOKA Co., Ltd.), Fujicure FXR1081 (trade name; T & K TOKA Co., Ltd.), Fujicure FXR1061 (trade name; T & K TOKA Co., Ltd.), and Fujicure FXR1171 (trade name; T & K TOKA Co., Ltd.). Any one component (C) may be used alone, or two or more may be used in combination.

A content of component (C) in the epoxy resin composition is preferably 0.1 to 30 % by weight, more preferably 0.5 to 20 % by weight, and further preferably 1 to 10 % by weight, based on a total weight of the resin composition.

Some component (C) is provided in the form of a dispersion dispersed in an epoxy resin. When using component (C) in such a form, it is preferable that the ratio of the equivalent number of the epoxy group of the epoxy resin as a whole to the equivalent number of the thiol group of the component (B) ([the equivalent number of the epoxy group of the epoxy resin as a whole] / [the equivalent number of the thiol group of the component (B)]) is calculated by combining an equivalent number of the epoxy group of the epoxy resin in which the component (C) is dispersed and that of the component (A). In the present embodiment, the ratio of the equivalent number of the epoxy group of the epoxy resin as a whole to the equivalent number of the thiol group of the component (B) ([the equivalent number of the epoxy group of the epoxy resin as a whole] / [the equivalent number of the thiol group of the component (B)]) is preferably 0.1 to 10, more preferably 0.2 to 8, further preferably 0.3 to 6, particularly preferably 0.4 to 2, and most preferably 0.5 to 1.5.

In this description, when component (C) contains an epoxy resin, a halogen content of the epoxy resin is preferably 1600 ppm or less.

If desired, the epoxy resin composition of the present embodiment may contain optional components other than the above components (A) to (C), such as those described below, as necessary.

### - Thiol compound other than component (B)

The epoxy resin composition of the present embodiment may contain a thiol compound other than component (B) (hereinafter also referred to as "other thiol compound"). Examples of other thiol compounds include:
aliphatic thiol compounds such as ethanedithiol, propanedithiol, hexamethylenedithiol, decamethylenedithiol, tolylene-2,4-dithiol, 2,2-bis (mercaptomethyl)-1,3-propanedithiol, 2-(mercaptomethyl)-2-methyl-1,3-propanedithiol, and 2-ethyl-2-(mercaptomethyl)-1,3-propanedithiol;
aromatic thiol compounds such as benzenedithiol, toluenedithiol and xylenedithiol (p-xylenedithiol);
cyclic sulfide compounds such as 1,4-dithiane ring-containing polythiol compounds;
mercaptoalkyl sulfide compounds such as 3-thiapentane-1,5-dithiol and 4-mercaptomethyl-3,6-dithia-1,8-octanedithiol;
mercaptopropionic acid esters such as pentaerythritol tetrakis(3-mercaptopropionate);
epoxy resin terminal mercapto compounds;
mercaptoalkyl ether compounds such as 3,6-dioxa-1,8-octanedithiol, mercaptoalkyl ether disulfide compounds, 2,2'-[[2,2-bis[(2-mercaptoethoxy)methyl]-1,3-propanediyl]bis(oxy)]bisethanethiol, 3,3'-[[2,2-bis[(3-mercaptopropoxy)methyl]-1,3-propanediyl]bis(oxy)]bis-1-propanethiol, 3-[2,2-bis[(3-mercaptopropoxy)methyl] butoxy]-1-propanethiol, 3-(3-mercaptopropoxy)-2,2-bis[(3-mercaptopropoxy)methyl]-1-propanol, and 2,2-bis[(3-mercaptopropoxy)methyl]-1-butanol;
glycoluril type thiols such as 1,3,4,6-tetrakis(2-mercaptoethyl)glycoluril, and 1,3,4,6-tetrakis(3-mercaptopropyl)glycoluril; and
triazine type thiols such as 2-{2,4,6-trioxo-3,5-bis[2-(3-sulfanylpropanoyloxy)ethyl]-1,3,5-triazinane-1-yl}ethyl = 3-sulfanylpropionate, 1,3,5-tris[3-(2-mercaptoethylsulfanyl)propyl]isocyanurate, and tris(3-mercaptopropyl) isocyanurate.

Other examples of other thiol compounds include trimethylolpropane tris(3-mercaptopropionate), tris-[(3-mercaptopropionyloxy)-ethyl]-isocyanurate, tetraethyleneglycol bis(3-mercaptopropionate), dipentaerythritol hexakis(3-mercaptopropionate), pentaerythritol tetrakis(3-mercaptobutyrate), 1,3,5-tris(3-mercaptobutyryloxyethyl)-1,3,5-triazine-2,4,6(1H,3H,5H)-trione, 1,3,4,6-tetrakis(mercaptomethyl)glycoluril, 1,3,4,6-tetrakis(mercaptomethyl)-3a-methylglycoluril, 1,3,4,6-tetrakis(2-mercaptoethyl)-3a-methylglycoluril, 1,3,4,6-tetrakis(3-mercaptopropyl)-3a-methylglycoluril, 1,3,4,6-tetrakis(mercaptomethyl)-3a,6a-dimethylglycoluril, 1,3,4,6-tetrakis(2-mercaptoethyl)-3a,6a-dimethylglycoluril, 1,3,4,6-tetrakis(3-mercaptopropyl)-3a,6a-dimethylglycoluril, 1,3,4,6-tetrakis(mercaptomethyl)-3a,6a-diphenylglycoluril, 1,3,4,6-tetrakis(2-mercaptoethyl)-3a,6a-diphenylglycoluril, 1,3,4,6-tetrakis(3-mercaptopropyl)-3a,6a-diphenylglycoluril, 1,3,5-tris[2-(3-mercaptopropoxy)ethyl]isocyanurate, pentaerythritol tripropanethiol, 3-[2,3-bis(3-sulfanylpropoxy)propoxy]propane-1-thiol, pentaerythritol tetrapropanethiol, 1,2,3-tris(mercaptomethylthio)propane, 1,2,3-tris(2-mercaptoethylthio)propane, 1,2,3-tris(3-mercaptopropylthio)propane, 4-mercaptomethyl-1,8-dimercapto-3,6-dithiaoctane, 5,7-dimercaptomethyl-1,11-dimercapto-3,6,9-trithiaundecane, 4,7-dimercaptomethyl-1,11-dimercapto-3,6,9-trithiaundecane, 4,8-dimercaptomethyl-1,11-dimercapto-3,6,9-trithiaundecane, tetrakis(mercaptomethylthiomethyl)methane, tetrakis(2-mercaptoethylthiomethyl)methane, tetrakis(3-mercaptopropylthiomethyl)methane, 1,1,3,3-tetrakis(mercaptomethylthio)propane, 1,1,2,2-tetrakis(mercaptomethylthio)ethane, 1,1,5,5-tetrakis(mercaptomethylthio)-3-thiapentane, 1,1,6,6-tetrakis(mercaptomethylthio)-3,4-dithiahexane, 2,2-bis(mercaptomethylthio)ethanethiol, 3-mercaptomethylthio-1,7-dimercapto-2,6-dithiaheptane, 3,6-bis(mercaptomethylthio)-1,9-dimercapto-2,5,8-trithianonane, 3-mercaptomethylthio-1,6-dimercapto-2,5-dithiahexane, 1,1,9,9-tetrakis(mercaptomethylthio)-5-(3,3-bis(mercaptomethylthio)-1-thiapropyl)-3,7-dithianonane, tris(2,2-bis(mercaptomethylthio)ethyl)methane, tris(4,4-bis(mercaptomethylthio)-2-thiabutyl)methane, tetrakis(2,2-bis(mercaptomethylthio)ethyl)methane, tetrakis(4,4-bis(mercaptomethylthio)-2-thiabutyl)methane, 3,5,9,11-tetrakis(mercaptomethylthio)-1,13-dimercapto-2,6,8,12-tetrathiatridecane, 3,5,9,11,15,17-hexakis(mercaptomethylthio)-1,19-dimercapto-2,6,8,12,14,18-hexathianonadecane, 9-(2,2-bis(mercaptomethylthio)ethyl)-3,5,13,15-tetrakis(mercaptomethylthio)-1,17-dimercapto-2,6,8,10,12,16-hexathiaheptadecane, 3,4,8,9-tetrakis(mercaptomethylthio)-1,11-dimercapto-2,5,7,10-tetrathiaundecane, 3,4,8,9,13,14-hexakis(mercaptomethylthio)-1,16-dimercapto-2,5,7,10,12,15-hexathiahexadecane, 8-[bis(mercaptomethylthio)methyl]-3,4,12,13-tetrakis(mercaptomethylthio)-1,15-dimercapto-2,5,7,9,11,14-hexathiapentadecane, 4,6-bis[3,5-bis(mercaptomethylthio)-7-mercapto-2,6-dithiaheptylthio]-1,3-dithiane, 4-[3,5-bis(mercaptomethylthio)-7-mercapto-2,6-dithiaheptylthio]-6-mercaptomethylthio-1,3-dithiane, 1,1-bis[4-(6-mercaptomethylthio)-1,3-dithianylthio]-1,3-bis(mercaptomethylthio)propane, 1-[4-(6-mercaptomethylthio)-1,3-dithianylthio]-3-[2,2-bis(mercaptomethylthio)ethyl]-7,9-bis(mercaptomethylthio)-2.4.6,10-tetrathiaundecane, 3-[2-(1,3-dithiethanyl)]methyl-7,9-bis(mercaptomethylthio)-1,11-dimercapto-2,4,6,10-tetrathiaundecane, 9-[2-(1,3-dithiethanyl)]methyl-3,5,13,15-tetrakis(mercaptomethylthio)-1,17-dimercapto-2,6,8,10,12,16-hexathiaheptadecane, 3-[2-(1,3-dithiethanyl)]methyl-7,9,13,15-tetrakis(mercaptomethylthio)-1,17-dimercapto-2,4,6,10,12,16-hexathiaheptadecane, 4,6-bis[4-(6-mercaptomethylthio)-1,3-dithianylthio]-6-[4-(6-mercaptomethylthio)-1,3-dithianylthio]-1,3-dithiane, 4-[3,4,8,9-tetrakis(mercaptomethylthio)-11-mercapto-2,5,7,10-tetrathiaundecyl]-5-mercaptomethylthio-1,3-dithiolane, 4,5-bis[3,4-bis(mercaptomethylthio)-6-mercapto-2, 5-dithiahexylthio]-1,3-dithiolane, 4-[3,4-bis(mercaptomethylthio)-6-mercapto-2,5-dithiahexylthio]-5-mercaptomethylthio-1,3-dithiolane, 4-[3-bis(mercaptomethylthio)methyl-5,6-bis(mercaptomethylthio)-8-mercapto-2,4,7-trithiaoctyl]-5-mercaptomethylthio-1,3-dithiolane, 2-{bis[3,4-bis(mercaptomethylthio)-6-mercapto-2,5-dithiahexylthio]methyl}-1,3-dithietane, 2-[3,4-bis(mercaptomethylthio)-6-mercapto-2,5-dithiahexylthio]mercaptomethylthiomethyl-1,3-dithietane, 2-[3,4,8,9-tetrakis(mercaptomethylthio)-11-mercapto-2,5,7,10-tetrathiaundecylthio]mercaptomethylthiomethyl-1,3-dithietane, 2-[3-bis(mercaptomethylthio)methyl-5,6-bis(mercaptomethylthio)-8-mercapto-2,4,7-trithiaoctyl]mercaptomethylthiomethyl-1,3-dithietane, and 4-{1-[2-(1,3-dithiethanyl)]-3-mercapto-2-thiapropylthio}-5-[1,2-bis(mercaptomethylthio)-4-mercapto-3-thiabutylthio]-1,3-dithiolane.

These other thiol compounds may be used alone, or two or more may be used in combination.

In the present embodiment, a weight ratio of the thiol compound of component (B) to other thiol compounds in the epoxy resin composition ([thiol compound of component (B)] : [other thiol compounds]) is preferably set to be 100 : 0 to 1 : 99. Since component (B) has very few polar portions other than the thiol group in its structure compared with other conventional thiol compounds, the thiol group is relatively easy to approach a metal surface when contacting a highly polar surface such as a metal surface. Therefore, even when the content of component (B) in the epoxy resin composition is small, discoloration may occur on the metal substrate.

When a thiol compound other than component (B) is contained, it is preferable that the ratio of the equivalent number of the epoxy group of the epoxy resin as a whole to the equivalent number of the thiol group of the thiol compound as a whole ([the equivalent number of the epoxy group of the epoxy resin as a whole] / [the equivalent number of the thiol group of the thiol compound as a whole]) is calculated by combining an equivalent number of the thiol group of component (B) and that of a thiol compound other than component (B). In the present embodiment, the ratio of the equivalent number of the epoxy group of the epoxy resin as a whole to the equivalent number of the thiol group of the thiol compound as a whole ([the equivalent number of the epoxy group of the epoxy resin as a whole] / [the equivalent number of the thiol group of the thiol compound as a whole]) is preferably 0.1 to 10, more preferably 0.2 to 8, further preferably 0.3 to 6, particularly preferably 0.4 to 2, and most preferably 0.5 to 1.5.

### - Filler

The epoxy resin composition of the present embodiment may contain a filler to the extent that the effects of the present invention are not impaired. By including the filler in the epoxy resin composition, a coefficient of linear expansion of a cured product obtained by curing the epoxy resin composition can be reduced, and thermal cycle resistance can be improved. In addition, if the filler has a low elastic modulus, stress generated in the cured product can be relaxed, and long-term reliability can be improved. Fillers are roughly classified into inorganic fillers and organic fillers.

The inorganic filler is not particularly limited as long as it consists of a granular material formed of an inorganic material and has an effect of lowering the coefficient of linear expansion by addition. As the inorganic material, silica, talc, alumina, aluminum nitride, calcium carbonate, aluminum silicate, magnesium silicate, magnesium carbonate, barium sulfate, barium carbonate, calcium sulfate, aluminum hydroxide, calcium silicate, potassium titanate, titanium oxide, zinc oxide, silicon carbide, silicon nitride, boron nitride, or the like may be used. Any one of the inorganic fillers may be used alone, or two or more inorganic fillers may be used in combination. As the inorganic filler, it is preferable to use a silica filler because a filling amount can be increased. As the silica, amorphous silica is preferable. The surface of the inorganic filler may be surface-treated with a coupling agent such as a silane coupling agent.

Examples of the organic filler include a polytetrafluoroethylene (PTFE) filler, a silicone filler, an acrylic filler, a filler having a urethane skeleton, a filler having a butadiene skeleton, and a styrene filler. The organic filler may be surface-treated.

The shape of the filler is not particularly limited, and may be any of spherical, scalelike, needle-like, indefinite-shaped, and the like.

An average particle diameter of the filler is preferably 6.0 µm or less, more preferably 5.0 µm or less, and further preferably 4.0 µm or less. In this description, unless otherwise specified, the average particle diameter means a median diameter (d₅₀) of a volume basis measured by a laser diffraction method in accordance with ISO-13320 (2009). By setting the average particle diameter of the filler to the upper limit or less, sedimentation of the filler can be suppressed, formation of coarse particles can be suppressed, and abrasion of a nozzle of a jet dispenser and scattering of the resin composition discharged from the nozzle of the jet dispenser outside a desired region can be suppressed. The lower limit of the average particle diameter of the filler is not particularly limited, but from the view of a viscosity of the resin composition, it is preferably 0.005 µm or more, and more preferably 0.1 µm or more. In one aspect of the present embodiment, the average particle diameter of the filler is preferably 0.01 µm to 5.0 µm, and more preferably 0.1 µm to 3.0 µm. Fillers having different average particle diameters may be used in combination. For example, a filler having an average particle diameter of 0.005 µm or more and less than 0.1 µm and a filler having an average particle diameter of 0.1 µm to 6.0 µm may be used in combination.

A content of the filler in the epoxy resin composition of the present embodiment is preferably 15 to 50 % by weight, more preferably 20 to 45 % by weight, and further preferably 20 to 40 % by weight, based on a total weight of the epoxy resin composition.

### - Stabilizer

The epoxy resin composition of the present embodiment may contain a stabilizer, if desired, to the extent that the effects of the present invention are not impaired. The stabilizer can improve a storage stability and prolong a pot life of the epoxy resin composition of the present embodiment. Although various known stabilizers can be used as the stabilizer, at least one selected from the group consisting of a liquid boric acid ester compound, an aluminum chelate and an organic acid is preferable because of the high effect of improving the storage stability.

Examples of the liquid boric acid ester compounds include 2,2'-oxybis(5,5'-dimethyl-1,3,2-oxaborinane), trimethyl borate, triethyl borate, tri-n-propyl borate, triisopropyl borate, tri-n-butyl borate, tripentyl borate, triallyl borate, trihexyl borate, tricyclohexyl borate, trioctyl borate, trinonyl borate, tridecyl borate, tridodecyl borate, trihexadecyl borate, trioctadecyl borate, tris(2-ethylhexyloxy)borane, bis(1,4,7,10-tetraoxaundecyl) (1,4,7,10,13-pentaoxatetradecyl) (1,4,7-trioxaundecyl)borane, tribenzyl borate, triphenyl borate, tri-o-tolyl borate, tri-m-tolyl borate, and triethanolamine borate. Since the liquid boric acid ester compound is liquid at room temperature (25°C), the viscosity of the epoxy resin composition can be suppressed to a low level, which is preferable. As the aluminum chelate, for example, aluminum chelate A (manufactured by Kawaken Fine Chemical Co., Ltd.) can be used. As the organic acid, for example, barbituric acid can be used.

Any one of the stabilizers may be used alone, or two or more stabilizers may be used in combination.

When the stabilizer is added, the amount added thereof is preferably 0.01 to 30 % by weight, more preferably 0.05 to 25 % by weight, and further preferably 0.1 to 20 % by weight, based on a total weight of the epoxy resin composition.

### - Reactive diluent

The epoxy resin composition of the present embodiment may contain a reactive diluent, if desired, to the extent that the effects of the present invention are not impaired. In this description, the reactive diluent refers to a compound having one epoxy group (glycidyl group) and having a relatively low viscosity at room temperature.

The reactive diluent may contain, in addition to the epoxy group, other polymerizable functional groups such as an alkenyl group such as vinyl and allyl; and an unsaturated carboxylic acid residue such as acryloyl and methacryloyl, depending on the purpose.

Examples of the reactive diluents include monoepoxide compounds such as n-butyl glycidyl ether, 2-ethylhexyl glycidyl ether, phenyl glycidyl ether, cresyl glycidyl ether, p-s-butylphenyl glycidyl ether, styrene oxide, and α-pinene oxide; and
monoepoxide compounds having other functional groups such as allyl glycidyl ether, glycidyl methacrylate, and 1-vinyl-3,4-epoxycyclohexane.

When the reactive diluent is contained, the content thereof is preferably 1 to 150 parts by weight based on 100 parts by weight of the epoxy resin.

### - Other Additives

The epoxy resin composition of the present embodiment may further contain other additives such as a coupling agent, carbon black, titanium black, an ion trapping agent, a leveling agent, an antioxidant, a defoaming agent, a viscosity adjuster, a flame retardant, a colorant, a solvent, and the like, if desired, within a range that does not impair the purpose of the present embodiment. The kind and amount of each of the additives are as usual.

The method for producing the epoxy resin composition of the present embodiment is not particularly limited. For example, the epoxy resin composition of the present embodiment can be obtained by simultaneously or separately introducing components (A) to (C), and other optional components if necessary, into a suitable mixer, stirring and mixing while melting by heating, if necessary, to form a uniform composition. The mixer is not particularly limited, but a ricer, a Henschel mixer, a three-roll mill, a ball mill, a planetary mixer, a bead mill, and the like, each of which is equipped with a stirring device and a heating device, can be used. These devices may be used in combination as appropriate.

The epoxy resin composition of the present embodiment may be a one-pack resin composition configured as being contained in a single container, or a two-pack (or multi-pack) resin composition configured as being separated into two or more containers, depending on the application or the like. In the case of the two-pack (or multi-pack) resin composition, the components (A) to (C) and other optional components as necessary may be selected in the same manner as in the one-pack resin composition. In the case of the two-pack (or multi-pack) resin composition, the components (A) to (C) and other optional components as necessary may be separated into two packs or multiple packs by any way without any particular restriction. In the case of separating into two packs or multiple packs by any way, each pack may contain at least one selected from the components (A) to (C) and other optional components as necessary, the components (A) to (C) and other optional components as necessary may be contained in one pack, and there may be a pack consisting of only one of the components (A) to (C) and/or other optional components as necessary. For example, when separating into liquid A and liquid B, the way of separation may be as follows: liquid A: component (A), liquid B: component (B) and component (C); liquid A: component (A) and component (B), liquid B: component (C); liquid A: component (A) and component (B), liquid B: component (A) and component (C); liquid A: component (A) and component (B), liquid B: component (B) and component (C); liquid A: component (A) and component (C), liquid B: component (B); or liquid A: component (A) and component (C), liquid B: component (B) and component (C). When the components (A) to (C) are contained in liquid A, liquid B may contain one or more selected from the components (A) to (C). In addition, components other than the components (A) to (C) (for example, a thiol compound other than component (B)) may be contained in both or one of liquid A and liquid B in the above combination. When the components (A) to (C) are contained in liquid A and the other components are contained in liquid B, liquid A alone or liquid A and liquid B together may be regarded as the resin composition of the present embodiment. On the other hand, when the components (A) to (C) are contained in the other packs, respectively, the respective packs together may be regarded as the resin composition of the present embodiment. Examples of the case where the components (A) to (C) are contained in the other packs, respectively, include, a resin composition which is configured with the components (A) to (C) being separated into two or more containers, specifically, a kit consisting of a plurality of liquids containing any of the components (A) to (C).

The epoxy resin composition thus obtained is thermosetting, and under a temperature of 100°C, it is preferably cured within 5 hours, more preferably within 3 hours, and further preferably within one hour. When the epoxy resin composition of the present embodiment is used for manufacturing a semiconductor module including a component that deteriorates under a high temperature condition, the composition is preferably thermally cured at a temperature of 50 to 90°C for 30 to 120 minutes.

The epoxy resin composition of the present embodiment can be used, for example, as an adhesive or a sealant for fixing, bonding, or protecting a semiconductor device, an electronic component, or components constituting them, or as a raw material thereof.

### [Adhesive or Sealant]

The adhesive or sealant according to one embodiment of the present invention includes the epoxy resin composition of the above embodiment. The adhesive or sealant enables good fixing, bonding or protecting to engineering plastics (for example, LCP (liquid crystal polymer), polyamide, polycarbonate, and the like), ceramics and metals (for example, copper, nickel, and the like), and can be used for fixing, bonding or protecting components constituting semiconductor devices or electronic components. Examples of semiconductor devices include, but are not limited to, HDDs, semiconductor elements, optical sensor modules such as image sensor modules and TOF sensor modules, semiconductor modules and integrated circuits.

The adhesive or sealant according to the present embodiment may be a one-pack adhesive or sealant configured as being contained in a single container, or a two-pack (or multi-pack) adhesive or sealant configured as being separated into two or more containers, depending on the application or the like. When the adhesive or sealant is used as a two-pack (or multi-pack) adhesive or sealant, the components (A) to (C) and other optional components as necessary may be selected in the same manner as in the one-pack adhesive or sealant, and the curing method is also the same as in the one-pack adhesive or sealant. In addition, when the adhesive or sealant is used as a two-pack (or multi-pack) adhesive or sealant, the components (A) to (C) and other optional components as necessary may be separated into two packs or multiple packs by any way without any particular restriction. When the adhesive or sealant is separated into two packs or multiple packs by any way, each pack may contain at least one selected from the components (A) to (C) and other optional components as necessary, the components (A) to (C) and other optional components as necessary may be contained in one pack, and there may be a pack consisting of only one of the components (A) to (C) and/or other optional components as necessary. For example, when separating into liquid A and liquid B, the way of separation may be as follows: liquid A: component (A), liquid B: component (B) and component (C); liquid A: component (A) and component (B), liquid B: component (C); liquid A: component (A) and component (B), liquid B: component (A) and component (C); liquid A: component (A) and component (B), liquid B: component (B) and component (C); liquid A: component (A) and component (C), liquid B: component (B); or liquid A: component (A) and component (C), liquid B: component (B) and component (C). When the components (A) to (C) are contained in liquid A, liquid B may contain one or more selected from the components (A) to (C). In addition, components other than the components (A) to (C) (for example, a thiol compound other than component (B)) may be contained in both or one of liquid A and liquid B in the above combination. When the components (A) to (C) are contained in liquid A and the other components are contained in liquid B, liquid A alone or liquid A and liquid B together may be regarded as the adhesive or sealant of the present embodiment. On the other hand, when the components (A) to (C) are contained in the other packs, respectively, the respective packs together may be regarded as the adhesive or sealant of the present embodiment. Examples of the case where the components (A) to (C) are contained in the other packs, respectively, include, an adhesive or sealant which is configured with the components (A) to (C) being separated into two or more containers, specifically, a kit consisting of a plurality of liquids containing any of the components (A) to (C).

### [Cured Product of Resin Composition, Adhesive or Sealant]

The cured product of one embodiment of the present invention is a cured product obtained by curing the epoxy resin composition, adhesive or sealant of the above-described embodiment. Discoloration of an adherend (especially metal) to which the cured product is bonded is suppressed.

### [Semiconductor device and electronic component]

The semiconductor device or electronic component according to one embodiment of the present invention includes the cured product according to the embodiment described above. Here, the semiconductor device refers to all devices which can function by utilizing semiconductor characteristics, and includes electronic components, semiconductor circuits, modules incorporating these, electronic equipment, and the like. Examples of the semiconductor devices or electronic components include, but are not limited to, HDDs, semiconductor elements, optical sensor modules such as image sensor modules and TOF sensor modules, other semiconductor modules, and integrated circuits.

### Examples

Hereinafter, the present invention will be described in more detail with reference to examples and comparative examples, but the present invention is not limited to these examples. In the following examples, parts and % indicate parts by weight and % by weight, unless otherwise specified.

### [Examples 1 to 2, Comparative Examples 1 to 3, and Reference Example 1]

Epoxy resin compositions were prepared by mixing a predetermined amount of each component using a three-roll mill according to formulations shown in Table 1. In Table 1, the amount of each component is expressed in parts by weight (unit: g). The components used in Examples and Comparative Examples are as follows.

### - (A) Epoxy resin having a halogen content of 1600 ppm or less

(A-1): YDF-8170 (bisphenol F-type liquid epoxy resin, manufactured by NIPPON STEEL Chemical & Material Co., Ltd., total chlorine content: 900 ppm, epoxy equivalent weight: 159 g/eq)
(A-2): jER828EL (bisphenol A-type diglycidyl ether, high purity product of jER828, manufactured by Mitsubishi Chemical Corporation, total chlorine content: 1430 ppm, epoxy equivalent weight: 189 g/eq)

### - (A') Epoxy resin having a halogen content of more than 1600 ppm

(A' -1): EP-4003S (bisphenol A-PO type, manufactured by ADEKA CORPORATION, total chlorine content: 1800 ppm, epoxy equivalent weight: 255 g/eq)
(A'-2): EPOX MK R540 (low chlorine product) (epoxy resin based on diglycidyl ester of hexahydrophthalic anhydride, manufactured by AIR WATER INC., total chlorine content: 3000 ppm, epoxy equivalent weight: 162.5 g/eq)
(A'-3): EPOX MK R540 (epoxy resin based on diglycidyl ester of hexahydrophthalic anhydride, manufactured by Air Water INC., total chlorine content: 10,000 ppm, epoxy equivalent weight: 162.5 g/eq)

The total chlorine content of the epoxy resin is determined by a sample combustion-ion chromatography method in accordance with BS EN 14582:2007.

### - (B) Thiol compound represented by chemical formula (I)

(B-1): A thiol compound represented by chemical formula (I) (1,2,3-(3-mercaptopropyloxy)propane) (available from SHIKOKU CHEMICALS CORPORATION, thiol equivalent weight: 106 g/eq). This thiol equivalent weight is an average value of values measured by a known method, for example, a method disclosed in paragraph 0079 of Japanese Patent Application Laid-Open No. 2012-153794.

### - (B') Thiol compound other than component (B)

(B'-1): 1,3,4,6-tetrakis(3-mercaptopropyl)glycoluril represented by the following formula (trade name: C3 TS-G, manufactured by SHIKOKU CHEMICALS CORPORATION, thiol equivalent weight: 110 g/eq)

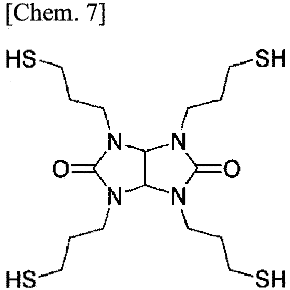

### - (C) Basic curing catalyst

(C-1): An amine-epoxy adduct based latent curing catalyst (trade name: Novacure HXA9322HP, manufactured by Asahi Kasei Corporation)

The latent curing catalyst (C-1) is provided in the form of a dispersion (the latent curing catalyst / a mixture of a bisphenol A-type epoxy resin and a bisphenol F-type epoxy resin = 33/67 (weight ratio)) in which the latent curing catalyst in particulate form is dispersed in an epoxy resin (the mixture of a bisphenol A-type epoxy resin and a bisphenol F-type epoxy resin (epoxy equivalent weight: 180 g/eq)).

In the Examples, Comparative Examples and Reference Example, the properties of the resin compositions were measured as follows.

### [Evaluation of Substrate Discoloration]

A copper (Cu) substrate and a nickel (Ni) substrate were coated with 0.05 g of each resin composition in a circular shape, respectively, and the samples obtained were subjected to a thermosetting treatment by heating at 80°C for 60 minutes in a blower dryer to produce a cured product on the substrate. The obtained cured product samples were placed in a constant temperature and humidity chamber under an environment of 85°C and 85% relative humidity for 20 hours. Presence or absence of discoloration of the substrate after standing for 20 hours was visually confirmed. The presence or absence and the degree of discoloration were evaluated according to the following criteria. The measurement results are shown in Table 1. Fig. 1 is a photograph taken from above of copper substrates used for discoloration evaluation of Example 1, Comparative Example 2, and Reference Example 1, after standing under an 85°C/85%RH environment for 20 hours. The same evaluation was also performed for a two-pack resin composition of the composition of Example 1, in which liquid A was component (A) and liquid B was components (B) and (C).
"-": No discoloration of the substrate was confirmed.
"+": Some discoloration of the substrate was confirmed.
"+ +": Significant discoloration of the substrate was confirmed.

### [Table 1]

**Table 1**

| | Example 1 | Example 2 | Comparative Example 1 | Comparative Example 2 | Comparative Example 3 | Reference Example 1 |
|---|---|---|---|---|---|---|
| (A-1) | 53.00 | | | | | |
| (A-2) | | 56.80 | | | | |
| (A'-1) | | | 73.40 | | | |
| (A'-2) | | | | 53.50 | | 54.69 |
| (A'-3) | | | | | 53.50 | |
| (B-1) | 41.00 | 37.20 | 20.60 | 40.50 | 40.50 | |
| (B'-1) | | | | | | 39.31 |
| (C-1) | 6.00 | 6.00 | 6.00 | 6.00 | 6.00 | 6.00 |
| Total | 100.00 | 100.00 | 100.00 | 100.00 | 100.00 | 100.00 |
| Discoloration evaluation of copper substrate under 85° C/85%RH environment for 20 hours | - | - | + | ++ | ++ | - |

The copper substrates coated with the epoxy resin compositions of Examples 1 and 2 containing an epoxy resin having a halogen content of 1600 ppm or less showed no discoloration even after standing under an 85°C/85%RH environment for 20 hours.

On the other hand, the copper substrates coated with the epoxy resin compositions of Comparative Examples 1 to 3, which did not contain an epoxy resin having a halogen content of 1600 ppm or less but contained an epoxy resin having a halogen content of more than 1600 ppm, showed discoloration after standing under an 85°C/85%RH environment for 20 hours.

The epoxy resin composition of Reference Example 1 containing another thiol compound instead of the thiol compound represented by chemical formula (I) showed no discoloration of the copper substrate even after standing under an 85°C/85%RH environment for 20 hours, even if the resin composition contained an epoxy resin having a halogen content of more than 1600 ppm. This shows that the substrate discoloration is a problem peculiar to the thiol compound represented by chemical formula (I).

Similar results were obtained for the nickel substrates to those for the copper substrates.

Although not shown in Table 1, the two-pack resin composition of the composition of Example 1, in which liquid A was component (A) and liquid B was components (B) and (C), was similarly evaluated, and the same result was obtained.

### Industrial applicability

The epoxy resin composition of the present invention can be used, for example, as an adhesive or a sealant for fixing, bonding or protecting a semiconductor device, an electronic component, or components constituting them, or as a raw material thereof, and is very useful.

The disclosure of Japanese Patent Application No. 2023-119048 (filing date: July 21, 2023) is incorporated herein by reference in its entirety.

All documents, patent applications, and technical standards described herein are incorporated herein by reference to the same extent as if the individual documents, patent applications, and technical standards were specifically and individually noted as being incorporated by reference.

## Claims

1. An epoxy resin composition comprising
(A) an epoxy resin having a halogen content of 1600 ppm or less,
(B) a thiol compound represented by chemical formula (I): 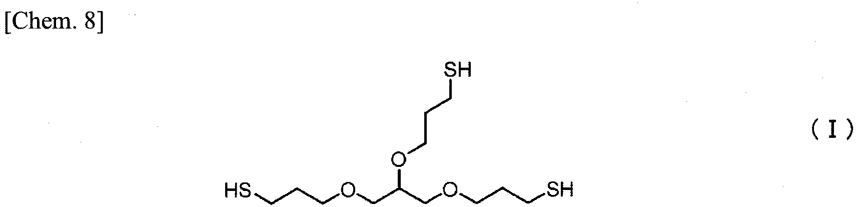
and (C) a basic curing catalyst.

2. The epoxy resin composition according to claim 1, wherein the (C) basic curing catalyst is a thermal latent curing catalyst.

3. The epoxy resin composition according to claim 1 or 2, wherein a ratio of an equivalent number of the epoxy group of the component (A) to an equivalent number of the thiol group of the component (B) ([an equivalent number of the epoxy group of the component (A)] / [an equivalent number of the thiol group of the component (B)]) is 0.1 to 10.

4. The epoxy resin composition according to any one of claims 1 to 3, which is configured with the components (A) to (C) being contained in a single container.

5. The epoxy resin composition according to any one of claims 1 to 3, which is configured with the components (A) to (C) being separated into two or more containers.

6. An adhesive or sealant comprising the epoxy resin composition according to any one of claims 1 to 5.

7. The adhesive or sealant according to claim 6, which is for a semiconductor device or an electronic component.

8. A cured product in which the epoxy resin composition according to any one of claims 1 to 5, or the adhesive or sealant according to claim 6 or 7 has been cured.

9. A semiconductor device or an electronic component comprising the cured product according to claim 8.
